# EUROPEAN PATENT APPLICATION

(11) **EP 4 675 985 A1**
(43) Date of publication of application: **07.01.2026**
(21) Application number: 25187557.1
(22) Date of filing: 04.07.2025
(51) Int. Cl.: H04L 25/03

(54) **CONTINUOUS TIME LINEAR EQUALIZER WITH ONE CIRCUIT PATH THAT USES TRANSMISSION LINE TO CONTROL PULSE WIDTH OF TIME-DOMAIN RESPONSE**

(30) Priority: 05.07.2024 US 202463667844 P; 01.07.2025 US 202519256203
(71) Applicant: MEDIATEK INC., Hsinchu City 30078 (TW)
(72) Inventor: PARK, Henry Arnold, San Jose, 95134 (US); GANDARA, Miguel Francisco, San Jose, 95134 (US); ALI, Tamer Mohammed, San Jose, 95134 (US)
(74) Representative: Haseltine Lake Kempner LLP

(57) **Abstract**

A continuous time linear equalizer (100) includes a first circuit path (106) and a second circuit path (108). The first circuit path (106) has a first step response. The second circuit path (108) is in parallel with the first circuit path (106). The second circuit path (108) has a second step response with a pulse response, and includes a transmission line (112) that is configured to control a pulse width of the pulse response according to a length of the transmission line (112). An output signal of the continuous time linear equalizer (100) is derived from an output signal of the first circuit path (106) and an output signal of the second circuit path (108).

## Description

### Field of the Invention

The present invention relates to a continuous time linear equalizer (CTLE), and more particularly, to a CTLE with one circuit path that uses a transmission line to control a pulse width of a time-domain response.

### Background of the Invention

Signal power is lost as signals propagate through a channel. Continuous time linear equalizers (CTLEs) are circuits that can compensate for the loss of signal power (also called insertion loss). The insertion loss is frequency dependent. Hence, the channel has a frequency-dependent gain that decreases at higher frequencies. A short reach channel may have a relatively low insertion loss (e.g., -5 dB) at the Nyquist frequency, while a long reach channel may have a higher insertion loss (e.g., -35 dB) at the Nyquist frequency. To compensate for the frequency-dependent insertion loss of the channel, the receiver-side CTLE is required to have a desired frequency-dependent gain that increases with frequency.

### Summary of the Invention

The scope of the present invention is defined by the claims.

This in mind, the present invention aims at providing a continuous time linear equalizer (CTLE) with one circuit path that uses a transmission line to control a pulse width of a time-domain response.

This is achieved by a CTLE according to the independent claim. The dependent claims pertain to corresponding further developments and improvements.

As will be seen more clearly from the detailed description following below, the claimed CTLE includes a first circuit path and a second circuit path. The first circuit path has a first step response. The second circuit path is in parallel with the first circuit path. The second circuit path has a second step response with a pulse response, and includes a transmission line that is configured to control a pulse width of the pulse response according to a length of the transmission line. An output signal of the CTLE is derived from an output signal of the first circuit path and an output signal of the second circuit path.

### Brief Description of the Drawings

In the following, the invention is further illustrated by way of example, taking reference to the accompanying drawings. Thereof
FIG. 1 is a diagram illustrating a CTLE with multiple circuit paths according to an embodiment of the present invention,
FIG. 2 is a diagram showing that the CTLE may have a frequency-dependent gain that increases with frequency,
FIG. 3 is a diagram showing that a step response of the CTLE may be decomposed into step responses of multiple circuit paths of the CTLE,
FIG. 4 is a diagram showing that a time-domain pulse response can be achieved by leveraging inherent characteristics of a transmission line according to an embodiment of the present invention,
FIG. 5 is a diagram illustrating a single-ended version of a second circuit path according to an embodiment of the present invention,
FIG. 6 is a diagram illustrating a differential version of a second circuit path according to an embodiment of the present invention,
FIG. 7 is a diagram illustrating a first alternative design of a second circuit path according to an embodiment of the present invention,
FIG. 8 is a diagram illustrating a second alternative design of a second circuit path according to an embodiment of the present invention,
FIG. 9 is a diagram illustrating a third alternative design of a second circuit path according to an embodiment of the present invention,
FIG. 10 is a diagram illustrating a single-ended version of a first circuit path according to an embodiment of the present invention,
FIG. 11 is a diagram illustrating a differential version of a first circuit path according to an embodiment of the present invention,
FIG. 12 is a diagram illustrating a single-ended version of a summing circuit according to an embodiment of the present invention, and
FIG. 13 is a diagram illustrating a differential version of a summing circuit according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

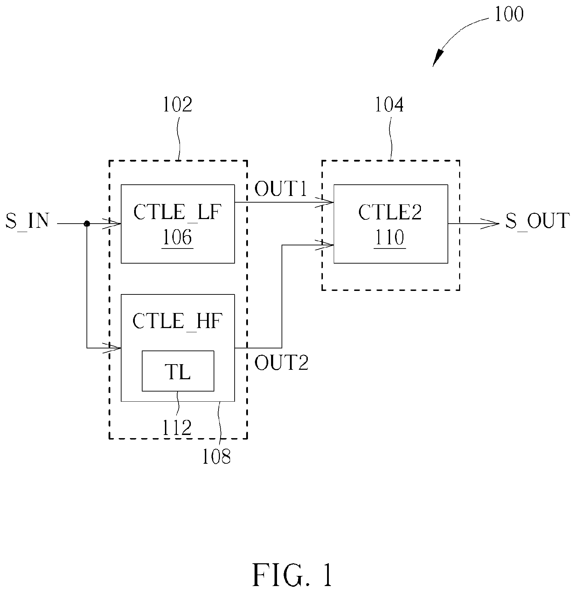

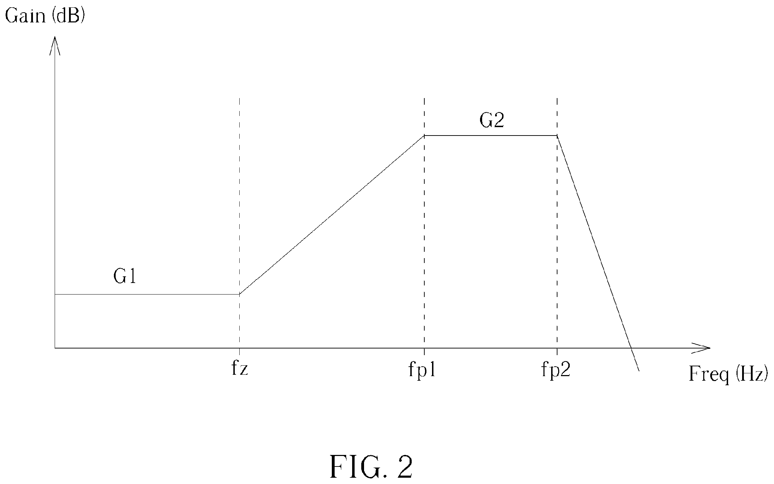

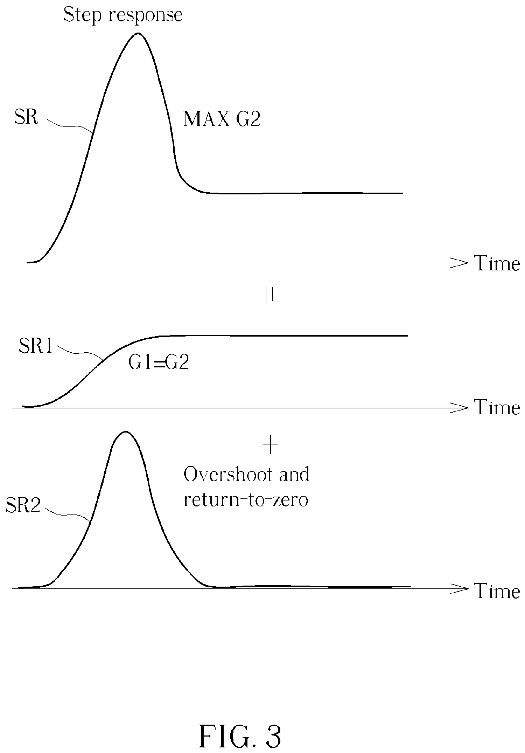

FIG. 1 is a diagram illustrating a CTLE with multiple circuit paths according to an embodiment of the present invention. The proposed CTLE 100 has two stages, including a first stage 102 and a second stage 104. The first stage 102 has a first circuit path (labeled by "CTLE_LF") 106 and a second circuit path (labeled by "CTLE _HF). The second stage 104 includes a summing circuit (labeled by "CTLE2") 110. To compensate for the frequency-dependent insertion loss of a channel between a transmitter and a receiver, the CTLE 100 at the receiver may be designed to have a desired frequency-dependent gain that increases with frequency, as shown in FIG. 2. For example, the gain of the CTLE 100 may increase from a gain of G1 to G2 (G2 > G1) between frequencies fz and fp1. Hence, the time-domain response of the CTLE 100 may have a step response SR shown in FIG. 3. The step response SR can be decomposed into a first step response SR1 and a second step response SR2. For example, the first step response SR1 is a critically damped response without overshoot (i.e., a non-pulse response in the time domain), and the second step response SR2 has an overshoot and return-to-zero pulse (i.e., a pulse response in the time domain). Specifically, the first step response SR1 increases from a first initial value (e.g., a zero value or a close-to-zero value) to a first steady state value higher than the first initial value, and the second step response SR2 increases from a second initial value (e.g., a zero value or a close-to-zero value) to a peak and subsequently falls to a second steady state that is approximately the same as the second initial value.

Since the step response SR can be decomposed into the first step response SR1 and the second step response SR2, the CTLE 100 can have the step response SR by using the first circuit path 106 configured to have the first step response SR1 and the second circuit path 108 configured to have the second step response SR2. Since the second circuit path 108 is in parallel with the first circuit path 106, the same input signal S_IN of the CTLE 100 is received by both of the first circuit path 106 and the second circuit path 108. An output signal S_OUT of the CTLE 100 is derived from an output signal OUT1 of the first circuit path 106 and an output signal OUT2 of the second circuit path 108. In this embodiment, the summing circuit 110 is configured to combine the output signal OUT1 of the first circuit path 106 and the output signal OUT2 of the second circuit path 108 to generate the output signal S_OUT of the CTLE 100.

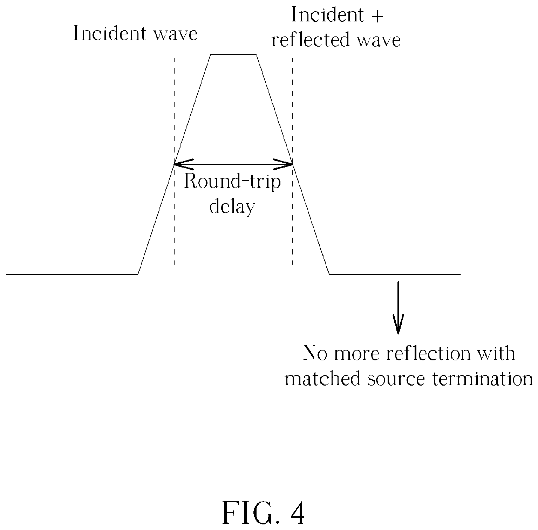

The second circuit path 108 is designed to have the second step response SR2 with a pulse response. In this embodiment, the second circuit path 108 has a transmission line (TL) 112 configured to control a pulse width of the pulse response according to a length of the transmission line 112. In other words, the time-domain pulse response can be achieved by leveraging inherent characteristics of the transmission line 112, as illustrated in FIG. 4. The pulse width of the time-domain pulse response is determined by a round-trip delay that depends on the length of the transmission line 112. It should be noted that the pulse width of the time-domain pulse response determines a peaking frequency fp of a corresponding frequency-domain response. For example, a narrower time-domain pulse response results in higher-frequency gain peaking of the frequency-domain response, and a wider time-domain pulse response results in lower-frequency gain peaking of the frequency-domain response.

Further circuit design details of the proposed CTLE 100 are described as below with reference to the accompanying drawings.

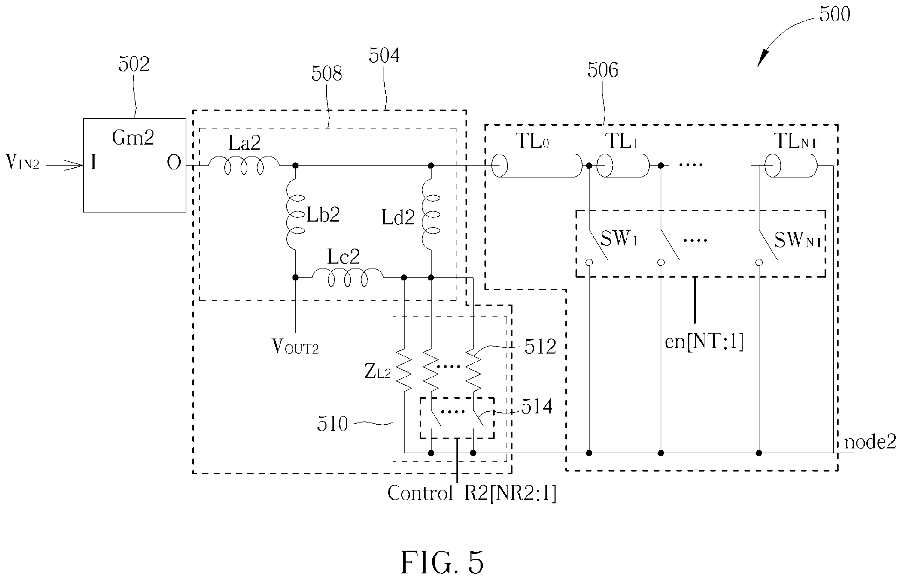

FIG. 5 is a diagram illustrating a single-ended version of a second circuit path according to an embodiment of the present invention. In a case where the proposed CTLE 100 operates under a single-ended mode, the second circuit path 108 shown in FIG. 1 may be implemented using the second circuit path 500. The second circuit path 500 includes a transconductance (Gm) cell (labeled by "Gm2") 502, an output network 504, and a transmission line 506. The Gm cell 502 has an input node I and an output node O, and is configured to convert a voltage input at the input node I to a current output at the output node O. In this embodiment, the input node I of the Gm cell 502 is configured to receive an input signal (voltage input) V_{IN2} of the second circuit path 500.

The output network 504 is coupled to the output node O of the Gm cell 502, a first end of the transmission line 506 and a reference node node2. For example, the reference node node2 may be a ground node. The output network 504 is configured to receive the current output of the Gm cell 502, and generate an output signal (voltage output) V_{OUT2} of the second circuit path 500. **In** this embodiment, the output network 504 includes a resistor-inductor (RL) circuit. As shown in FIG. 5, the output network 504 includes an inductive network 508 and a termination resistor 510. The inductive network 508 is used for bandwidth extension, and includes at least one inductor. For example, the inductive network 508 includes inductors La2, Lb2, Lc2, Ld2. The inductance value of the inductor La2/Lb2/Lc2/Ld2 may be a zero value (short), a non-zero value (e.g., 10nH), or an infinity value (open), depending upon actual design considerations. For example, the inductor La2 may be replaced by a short circuit. For another example, the inductor Lb2 may be replaced by an open circuit. To put it simply, the present invention has no limitations on the actual implementation of the inductive network 508. It should be noted that a magnetic coupling can be present between any two inductors.

**In** this embodiment, the termination resistor 510 is programmable. As shown in FIG. 5, the termination resistor 510 includes a first resistor Z_{L2}, a plurality of second resistors 512, and a plurality of switch circuits 514. The number of second resistors 512 included in a resistor array is equal to NR2. Since one switch circuit 514 and one second resistor 512 are connected in series, the number of switch circuits 514 is also equal to NR2. Each of the first resistor Z_{L2} and the second resistors 512 has a first end and a second end, and the first end of each second resistor 512 is coupled to the first end of the first resistor Z_{L2}. The switch circuits 514 are coupled to second ends of the second resistors 512, respectively. Specifically, each switch circuit 514 is coupled between a second end of a corresponding second resistor 512 and the second end of the first resistor Z_{L2}. The switch circuits 514 are controlled by a switch control input Control_R2[NR2:1]. Hence, the switch control input Control_R2[NR2:1] can be programmed to determine the number of second resistors 512 that are connected to the first resistor Z_{L2} in parallel. For example, when none of the switch circuits 514 is switched on, the termination resistor 510 is set by a fixed resistor (i.e., first resistor Z_{L2}).

In this embodiment, the second circuit path 500 is configured to provide a time-domain response with a pulse response (e.g., second step response SR2 shown in FIG.3). The transmission line 506 can be programmable to vary the pulse width of the pulse response to meet the requirements of different communication standards or speeds. As shown in FIG. 5, the transmission line 506 includes a first transmission line segment TL₀, a plurality of second transmission line segments TL₁-TL_{NT}, and a plurality of switch circuits SW₁-SW_{NT}. Each of the first transmission line segment TL₀ and the second transmission line segments TL₁-TL_{NT} has a first end and a second end. The second transmission line segments TL₁-TL_{NT} are connected in series between the second end of the first transmission line segment TL₀ and the reference node node2. The switch circuits SW₁-SW_{NT} are coupled to first ends of the second transmission line segments TL₁-TL_{NT}, respectively. Specifically, each of the switch circuits SW₁-SW_{NT} is coupled between a first end of a corresponding second transmission line segment and the reference node node2. The switch circuits SW₁-SW_{NT} are controlled by a switch control input en[NT:1]. Hence, the switch control input en[NT:1] determines the second transmission line segments that are bypassed to the reference node node2 (e.g., ground node). In other words, the switch control input en[NT:1] can be programed to determine the length of the transmission line 506. For example, when none of the switch circuits SW₁-SW_{NT} is switched on, the transmission line 506 has a maximum length contributed by all transmission line segments TL₀-TL_{NT}. For another example, when the switch circuit SW₁ is switched on, the transmission line 506 has a minimum length solely contributed by the transmission line segment TL₀ with a fixed length.

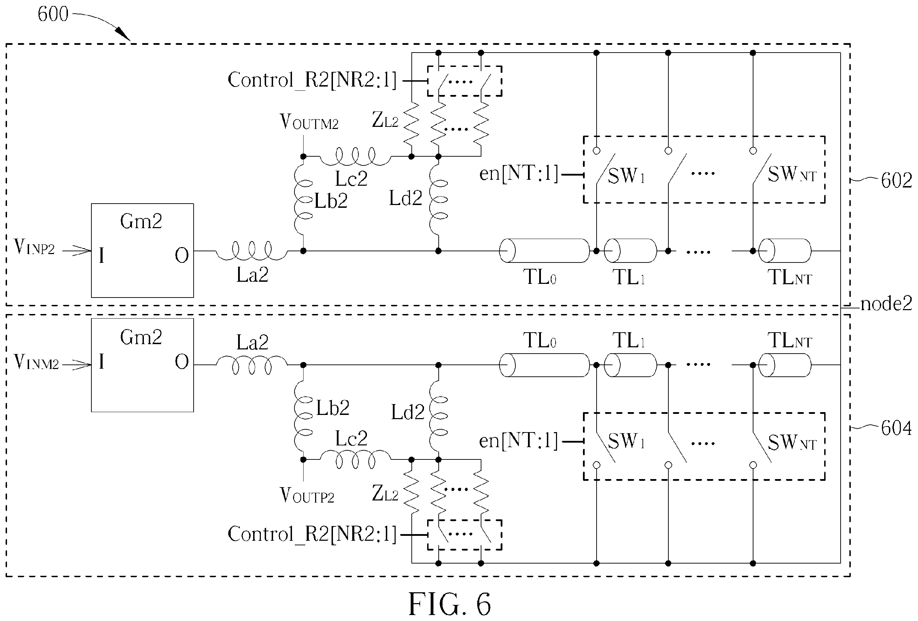

FIG. 6 is a diagram illustrating a differential version of a second circuit path according to an embodiment of the present invention. In a case where the proposed CTLE 100 operates under a differential mode, the second circuit path 108 shown in FIG. 1 may be implemented using the second circuit path 600. The second circuit path 600 may be constructed by using two second circuit paths 500 connected to the same reference node node2 that acts as a common-mode node. As shown in FIG. 6, a top half 602 of the second circuit path 600 is configured to receive an input signal (voltage input) V_{INP2} and generate an output signal (voltage output) V_{OUTM2}, and a bottom half 604 of the second circuit path 600 is configured to receive an input signal (voltage input) V_{INM2} and generate an output signal (voltage output) V_{OUTP2}, where the input signals V_{INP2} and V_{INM2} are a differential input of the second circuit path 600, and the output signals V_{OUTP2} and V_{OUTM2} are a differential output of the second circuit path 600. For example, the differential input of the second circuit path 600 may be the input signal S_IN of the CTLE 100. Each half of the second circuit path 600 has the same circuit design used by the second circuit path 500. Since a person skilled in the art can readily understand functions and operations of the second circuit path 600 after reading above paragraphs directed to the second circuit path 500, similar description is omitted here for brevity.

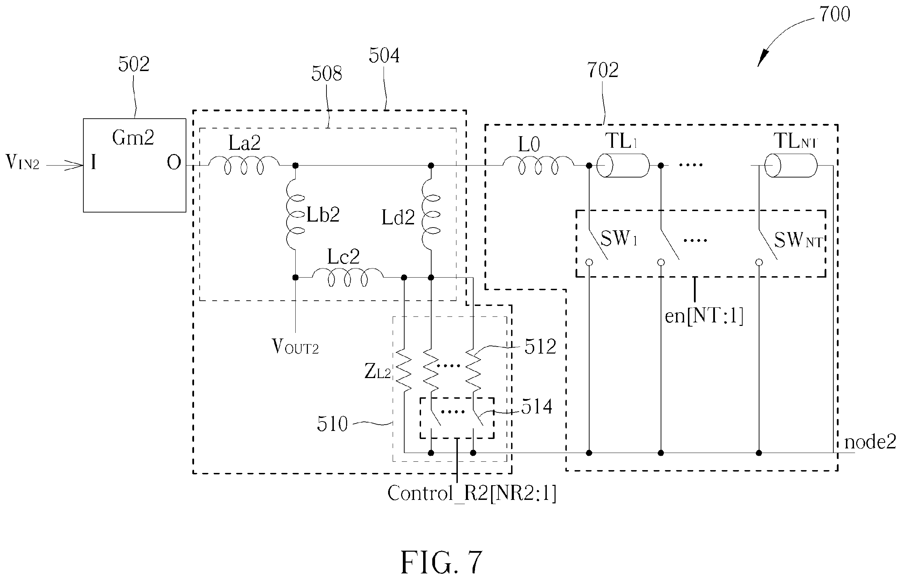

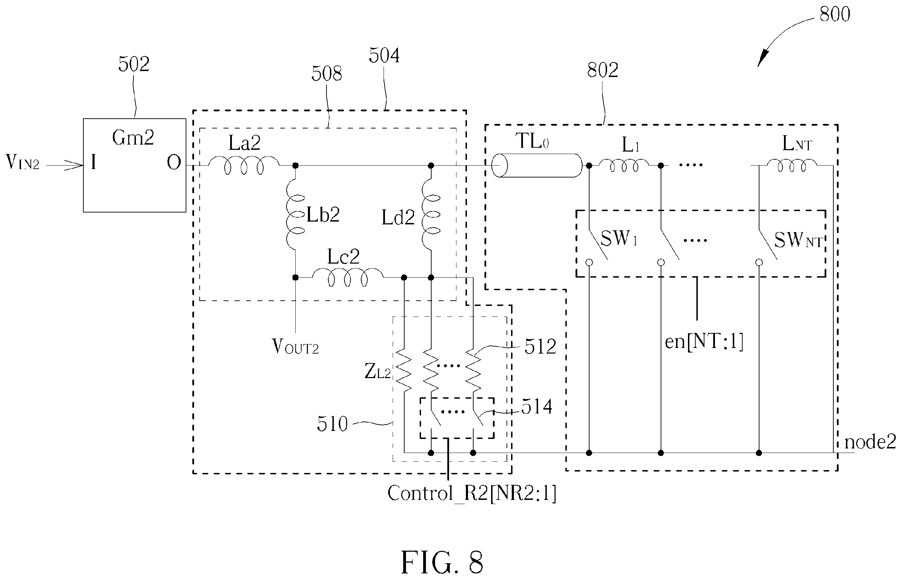

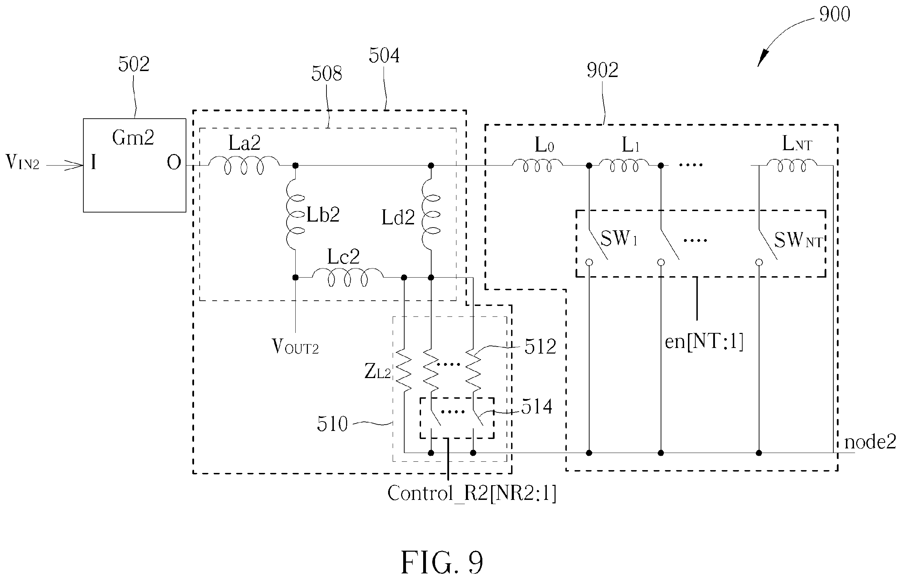

As mentioned above, the length of the transmission line determines the pulse width of the time-domain response (i.e., the peaking frequency of the frequency-domain response). In some embodiments of the present invention, components with characteristics similar to that of the transmission line may be employed to implement the transmission line. In a first alternative design of the second circuit path 500/600, the first transmission line segment TL₀ may be replaced by a spiral inductor L₀. For example, the transmission line 506 may be replaced by the transmission line 702 shown in FIG. 7. In a second alternative design of the second circuit path 500/600, the second transmission line segments TL₁-TL_{NT} may be replaced by spiral inductors L₁-L_{NT}. For example, the transmission line 506 may be replaced by the transmission line 802 shown in FIG. 8. In a third alternative design of the second circuit path 500/600, the first transmission line segment TL₀ and the second transmission line segments TL₁-TL_{NT} may be replaced by spiral inductors L₀-L_{NT}. For example, the transmission line 506 may be replaced by the transmission line 902 shown in FIG. 9.

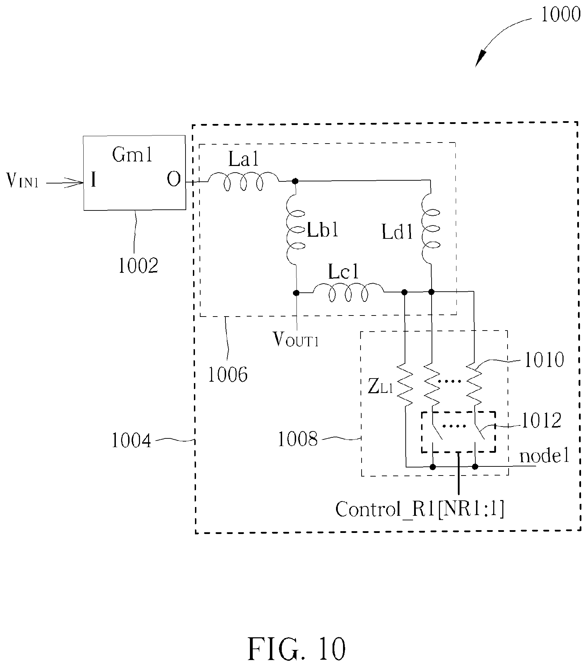

FIG. 10 is a diagram illustrating a single-ended version of a first circuit path according to an embodiment of the present invention. In a case where the proposed CTLE 100 operates under a single-ended mode, the first circuit path 106 shown in FIG. 1 may be implemented using the first circuit path 1000. The first circuit path 1000 includes a Gm cell (labeled by "Gm1") 1002 and an output network 1004. The Gm cell 1002 has an input node I and an output node O, and is configured to convert a voltage input at the input node I to a current output at the output node O. In this embodiment, the input node I of the Gm cell 1002 is configured to receive an input signal (voltage input) V_{IN1} of the first circuit path 1000. For example, the input signal (voltage input) V_{IN1} is the input signal S_IN of the CTLE 100.

The output network 1004 is coupled to the output node O of the Gm cell 1002 and a reference node node1. For example, the reference node node1 may be a ground node. The output network 1004 is configured to receive the current output of the Gm cell 1002, and generate an output signal (voltage output) V_{OUT1} of the first circuit path 1000. In this embodiment, the output network 1004 includes an RL circuit. As shown in FIG. 10, the output network 1004 includes an inductive network 1006 and a load resistor 1008. The inductive network 1006 is used for bandwidth extension, and includes at least one inductor. For example, the inductive network 1006 includes inductors La1, Lb1, Lc1, Ld1. The inductance value of the inductor La1/Lb1/Lc1/Ld1 may be a zero value (short), a non-zero value (e.g., 10nH), or an infinity value (open), depending upon actual design considerations. For example, the inductor La1 may be replaced by a short circuit. For another example, the inductor Lb1 may be replaced by an open circuit. To put it simply, the present invention has no limitations on the actual implementation of the inductive network 1006. It should be noted that, a magnetic coupling can be present between any two inductors.

The first circuit path 1000 is configured to provide a time-domain response without overshoot (e.g., first step response SR1 shown in FIG.3). The step response of the second circuit path 1000 may be adjustable, which can enable the second circuit path 1000 to meet the requirements of different communication standards or speeds.

In this embodiment, the load resistor 1008 is programmable. As shown in FIG. 10, the load resistor 1008 includes a first resistor Z_{L1}, a plurality of second resistors 1010, and a plurality of switch circuits 1012. The number of second resistors 1010 included in a resistor array is equal to NR1. Since one switch circuit 1012 and one second resistor 1010 are connected in series, the number of switch circuits 1012 is also equal to NR1. Each of the first resistor Z_{L1} and the second resistors 1010 has a first end and a second end, and the first end of each second resistor 1010 is coupled to the first end of the first resistor Z_{L1}. The switch circuits 1012 are coupled to second ends of the second resistors 1010, respectively. Specifically, each switch circuit 1012 is coupled between a second end of a corresponding second resistor 1010 and the second end of the first resistor Z_{L1}. The switch circuits 1012 are controlled by a switch control input Control_R1[NR1:1]. Hence, the switch control input Control_R1[NR1:1] can be programmed to determine the number of second resistors 1012 that are connected to the first resistor Z_{L1} in parallel. For example, when none of the switch circuits 1012 is switched on, the load resistor 1008 is set by a fixed resistor (i.e., first resistor Z_{L1}).

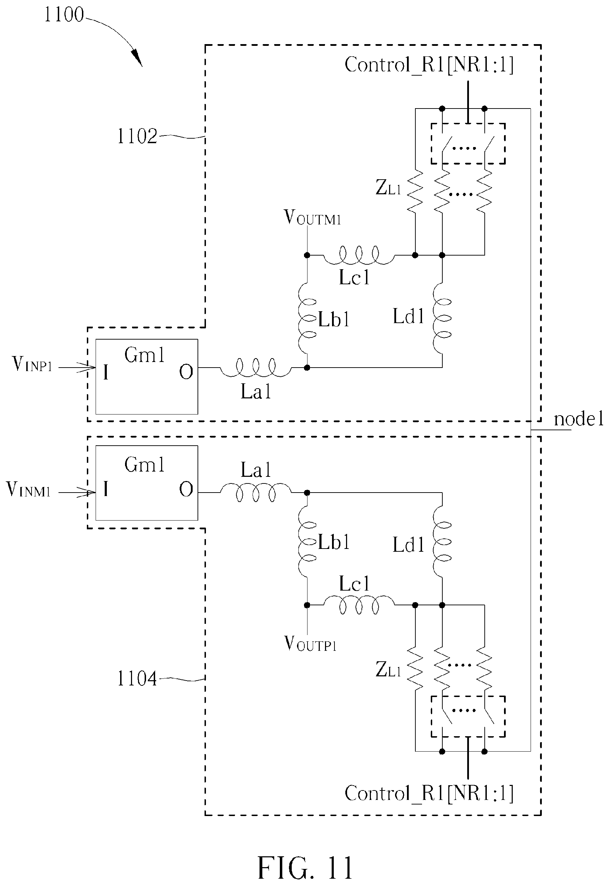

FIG. 11 is a diagram illustrating a differential version of a first circuit path according to an embodiment of the present invention. In a case where the proposed CTLE 100 operates under a differential mode, the first circuit path 106 shown in FIG. 1 may be implemented using the first circuit path 1100. The first circuit path 1100 may be constructed by using two first circuit paths 1000 connected to the same reference node node1 that acts as a common-mode node. As shown in FIG. 11, a top half 1102 of the first circuit path 1100 is configured to receive an input signal (voltage input) V_{INP1} and generate an output signal (voltage output) V_{OUTM1}, and a bottom half 1104 of the first circuit path 1100 is configured to receive an input signal (voltage input) V_{INM1} and generate an output signal (voltage output) V_{OUTP1}, where the input signals V_{INP2} and V_{INM2} are a differential input of the first circuit path 1100, and the output signals V_{OUTP2} and V_{OUTM2} are a differential output of the first circuit path 1100. For example, the differential input of the first circuit path 1100 is the input signal S_IN of the CTLE 100. Each half of the first circuit path 1100 has the same circuit design used by the first circuit path 1000. Since a person skilled in the art can readily understand functions and operations of the first circuit path 1100 after reading above paragraphs directed to the first circuit path 1000, similar description is omitted here for brevity.

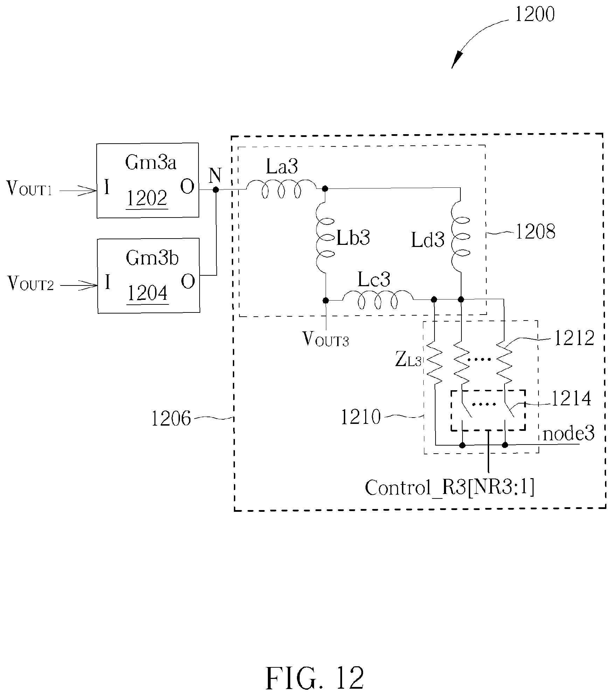

FIG. 12 is a diagram illustrating a single-ended version of a summing circuit according to an embodiment of the present invention. In a case where the proposed CTLE 100 operates under a single-ended mode, the summing circuit 110 shown in FIG. 1 may be implemented using the summing circuit 1200. The summing circuit 1200 includes a first Gm cell (labeled by "Gm3a") 1202, a second Gm cell (labeled by "Gm3b") 1204, and an output network 1206. Each of the first Gm cell 1202 and the second Gm cell 1204 has an input node I and an output node O, and is configured to convert a voltage input at the input node I to a current output at the output node O. In this embodiment, the input node I of the first Gm cell 1202 is configured to receive the output signal (voltage output) V_{OUT1} of the first circuit path 1000, and the input node I of the second Gm cell 1204 is configured to receive the output signal (voltage output) V_{OUT2} of the second circuit path 500. The output network 1004 is coupled to output nodes O of the first Gm cell 1202 and the second Gm cell 1204 and a reference node node3. For example, the reference node node3 may be a ground node. The current outputs of the first Gm cell 1202 and the second Gm cell 1204 are combined at an input node N of the output network 1206. The output network 1004 is configured to generate an output signal (voltage output) V_{OUT3} of the summing circuit 1200 according to the output signal (voltage output) V_{OUT1} of the first circuit path 1000 and the output signal (voltage output) V_{OUT2} of the second circuit path 500. For example, the output signal V_{OUT3} of the summing circuit 1200 can serve as the output signal S_OUT of the CTLE 100, and/or can be connected to another RLC network.

In this embodiment, the output network 1206 includes an RL circuit. As shown in FIG. 12, the output network 1206 includes an inductive network 1208 and a load resistor 1210. The inductive network 1208 is used for bandwidth extension, and includes at least one inductor. For example, the inductive network 1208 includes inductors La3, Lb3, Lc3, Ld3. The inductance value of the inductor La3/Lb3/Lc3/Ld3 may be a zero value (short), a non-zero value (e.g., 10nH), or an infinity value (open), depending upon actual design considerations. For example, the inductor La3 may be replaced by a short circuit. For another example, the inductor Lb3 may be replaced by an open circuit. To put it simply, the present invention has no limitations on the actual implementation of the inductive network 1208. It should be noted that a magnetic coupling can be present between two inductors.

A main objective of the summing circuit 1200 is to combine output signals of the first circuit path 1000 and the second circuit path 500 with different time-domain/frequency-domain responses. The summing circuit 1200 may have a time-domain/frequency-domain response that can be programmable to meet the requirements of different communication standards or speeds.

In this embodiment, the load resistor 1210 is programmable. As shown in FIG. 12, the load resistor 1210 includes a first resistor Z_{L3}, a plurality of second resistors 1212, and a plurality of switch circuits 1214. The number of second resistors 1212 included in a resistor array is equal to NR3. Since one switch circuit 1214 and one second resistor 1212 are connected in series, the number of switch circuits 1214 is also equal to NR3. Each of the first resistor Z_{L3} and the second resistors 1212 has a first end and a second end, and the first end of each second resistor 1212 is coupled to the first end of the first resistor Z_{L3}. The switch circuits 1214 are coupled to second ends of the second resistors 1212, respectively. Specifically, each switch circuit 1214 is coupled between a second end of a corresponding second resistor 1212 and the second end of the first resistor Z_{L3}. The switch circuits 1214 are controlled by a switch control input Control _R3[NR3:1]. Hence, the switch control input Control _R3[NR3:1] can be programmed to determine the number of second resistors 1214 that are connected to the first resistor Z_{L3} in parallel. For example, when none of the switch circuits 1214 is switched on, the load resistor 1210 is set by a fixed resistor (i.e., first resistor Z_{L3}).

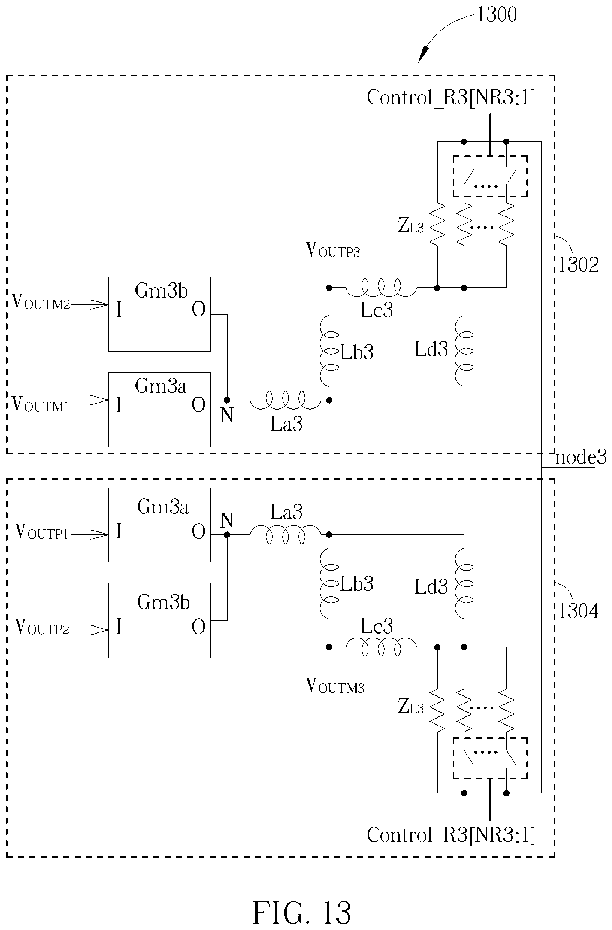

FIG. 13 is a diagram illustrating a differential version of a summing circuit according to an embodiment of the present invention. In a case where the proposed CTLE 100 operates under a differential mode, the summing circuit 110 shown in FIG. 1 may be implemented using the summing circuit path 1300. The summing circuit 1300 may be constructed by using two summing circuits 1200 connected to the same reference node node3 that acts as a common-mode node. As shown in FIG. 13, a top half 1302 of the summing circuit 1300 is configured to receive an output signal (voltage output) V_{OUTM1} of the first circuit path 1100 and an output signal (voltage output) V_{OUTM2} of the second circuit path 600, and generate an output signal (voltage output) V_{OUTM3}. A bottom half 1304 of the summing circuit 1300 is configured to receive an output signal (voltage output) V_{OUTP1} of the first circuit path 1100 and an output signal (voltage output) V_{OUTP2} of the second circuit path 600, and generate an output signal (voltage output) V_{OUTM3}. The output signals V_{OUTP3} and V_{OUTM3} are a differential output of the summing circuit 1300. For example, the differential output of the summing circuit 1300 can serve as the output signal S_OUT of the CTLE 100, and/or can be connected to another RLC network. Each half of the summing circuit 1300 has the same circuit design used by the summing circuit 1200. Since a person skilled in the art can readily understand functions and operations of the summing circuit 1300 after reading above paragraphs directed to the summing circuit 1200, similar description is omitted here for brevity.

**In** above embodiments, any of the Gm cells used in the first circuit path, the second circuit path, and the summing circuit may be implemented using a P-type source degenerated different pair, a P-type differential pair, a P-type inverter pair, an N-type source degenerated different pair, an N-type differential pair, an N-type inverter pair, or an arbitrary combination thereof. To put it simply, the present invention has no limitations on the actual Gm cell implementation. **In** practice, any Gm cell design capable of converting a single-ended/differential voltage input to a single-ended/differential current output can be employed by the proposed CTLE 100.

## Claims

1. A continuous time linear equalizer (100), hereinafter referred to as CTLE, **characterized by**:
a first circuit path (106, 1000, 1100), having a first step response; and
a second circuit path (108, 500, 600, 700, 800, 900), in parallel with the first circuit path (106, 1000, 1100), wherein the second circuit path (108, 500, 600, 700, 800, 900) has a second step response with a pulse response, and comprises:
a transmission line (112, 506, 702, 802, 902), configured to control a pulse width of the pulse response according to a length of the transmission line (112, 506, 702, 802, 902);
wherein an output signal (S_OUT) of the CTLE (100) is derived from an output signal (OUT1) of the first circuit path (106, 1000, 1100) and an output signal (OUT2) of the second circuit path (108, 500, 600, 700, 800, 900).

2. The CTLE (100) of claim 1, **characterized in that** the transmission line (112, 506, 702, 802, 902) is programmable to vary the pulse width of the pulse response.

3. The CTLE (100) of claim 2, **characterized in that** the transmission line (506, 702, 802, 902) comprises:
a first transmission line segment (TL₀, L0), having a first end and a second end;
a plurality of second transmission line segments (TL₁, TL_{NT}, L₁, L_{NT}), each having a first end and a second end, wherein the plurality of second transmission line segments (TL₁, TL_{NT}, L₁, L_{NT}) are connected in series between the second end of the first transmission line segment (TL₀, L0) and a reference node (node2); and
a plurality of first switch circuits (SW₁, SW_{NT}), coupled to first ends of the plurality of second transmission segments (TL₁, TL_{NT}, L₁, L_{NT}), respectively, wherein each of the plurality of first switch circuits (SW₁, SW_{NT}) is coupled between a first end of a corresponding second transmission line segment and the reference node (node2).

4. The CTLE (100) of claim 3, **characterized in that** the second circuit path (500, 600, 700, 800, 900) further comprises:
a transconductance cell (502), having an input node and an output node, wherein the input node of the transconductance cell (502) is configured to receive an input signal of the second circuit path (500, 600, 700, 800, 900); and
an output network (504), coupled to the output node of the transconductance cell (502), the first end of the transmission line (506, 702, 802, 902) and the reference node (node2), wherein the output network (504) is configured to generate the output signal of the second circuit path (500, 600, 700, 800, 900).

5. The CTLE (100) of claim 4, **characterized in that** the output network (504) comprises a resistor-inductor circuit.

6. The CTLE (100) of claim 5, **characterized in that** the resistor-inductor circuit comprises:
an inductive network (508), coupled to the output node of the transconductance cell (502) and the first end of the transmission line (506, 702, 802, 902), wherein the inductive network (508) comprises at least one inductor (La2, Lb2, Lc2, Ld2); and
a termination resistor (510), coupled between the inductive network (508) and the reference node (node2).

7. The CTLE (100) of claim 6, **characterized in that** the termination resistor (510) is programmable, and comprises:
a first resistor (Z_{L2}), having a first end and a second end;
a plurality of second resistors (512), each having a first end and a second end, wherein the first end of each second resistor (512) is coupled to the first end of the first resistor (Z_{L2}); and
a plurality of second switch circuits (514), coupled to second ends of the plurality of second resistors (512), respectively, wherein each of the plurality of second switch circuits (514) is coupled between a second end of a corresponding second resistor (512) and the second end of the first resistor (Z_{L2}).

8. The CTLE (100) of claim 1, **characterized in that** the first circuit path (1000, 1100) comprises:
a transconductance cell (1002), having an input node and an output node, wherein the input node of the transconductance cell (1002) is configured to receive an input signal of the first circuit path (1000, 1100); and
an output network (1004), coupled to the output node of the transconductance cell (1002), wherein the output network (1004) is configured to generate the output signal of the first circuit path (1000, 1100).

9. The CTLE (100) of claim 8, **characterized in that** the output network (1004) comprises a resistor-inductor circuit.

10. The CTLE (100) of claim 9, **characterized in that** the resistor-inductor circuit comprises:
an inductive network (1006), coupled to the output node of the transconductance cell (1002), wherein the inductive network (1006) comprises at least one inductor (La1, Lb1, Lc1, Ld1); and
a load resistor (1008), coupled between the inductive network (1006) and a reference node (node1).

11. The CTLE (100) of claim 1, **characterized in that** the CTLE (100) further comprises:
a summing circuit (110, 1200, 1300), configured to combine the output signal of the first circuit path (106, 1000, 1100) and the output signal of the second circuit path (108, 500, 600, 700, 800, 900) to generate the output signal of the CTLE (100).

12. The CTLE (100) of claim 11, **characterized in that** the summing circuit (1200, 1300) comprises:
a first transconductance cell (1202), having an input node and an output node, wherein the input node of the first transconductance cell (1202) is configured to receive the output signal of the first circuit path (106, 1000, 1100);
a second transconductance cell (1204), having an input node and an output node, wherein the input node of the second transconductance cell (1204) is configured to receive the output signal of the second circuit path (108, 500, 600, 700, 800, 900); and
an output network (1206), configured to generate the output signal of the CTLE (100) according to the output signal of the first circuit path (106, 1000, 1100) and the output signal of the second circuit path (108, 500, 600, 700, 800, 900).

13. The CTLE (100) of claim 12, **characterized in that** the output network (1206) comprises a resistor-inductor circuit.

14. The CTLE (100) of claim 13, **characterized in that** the resistor-inductor circuit comprises:
an inductive network (1208), coupled to the output node of the first transconductance cell (1202) and the output node of the second transconductance cell (1204), wherein the inductive network (1208) comprises at least one inductor (La3, Lb3, Lc3, Ld3); and
a load resistor (1210), coupled between the inductive network (1208) and a reference node (node3).

15. The CTLE (100) of any of claims 10 and 14, **characterized in that** the load resistor (1008, 1201) is programmable, and comprises:
a first resistor (Z_{L1}, Z_{L3}), having a first end and a second end;
a plurality of second resistors (1010, 1212), each having a first end and a second end, wherein the first end of each second resistor (1010, 1212) is coupled to the first end of the first resistor (Z_{L1}, Z_{L3}); and
a plurality of switch circuits (1012, 1214), coupled to second ends of the plurality of second resistors (1010, 1212), respectively, wherein each of the plurality of switch circuits (1012, 1214) is coupled between a second end of a corresponding second resistor (1010, 1212) and the second end of the first resistor (Z_{L1}, Z_{L3}).
